Europäisches Patentamt

**European Patent Office**

**Office européen des brevets**

(19)

(11) Publication number: **0 225 426 B1**

# EUROPEAN PATENT SPECIFICATION

(45) Date of publication of patent specification: **11.11.92**

(51) Int. Cl.⁵: **H01L 21/28**, H01L 21/00, H01L 29/78

(21) Application number: **86108855.7**

(22) Date of filing: **10.12.82**

(60) Publication number of the earlier application in accordance with Art.76 EPC: **0 081 999**

(54) **A method of fabricating a MOS transistor on a substrate.**

(30) Priority: **16.12.81 US 331474**

(43) Date of publication of application:
**16.06.87 Bulletin 87/25**

(45) Publication of the grant of the patent:
**11.11.92 Bulletin 92/46**

(84) Designated Contracting States:
**DE FR GB NL**

(56) References cited:
**EP-A- 0 036 573**
**GB-A- 2 074 374**
**US-A- 3 849 216**
**US-A- 4 182 023**
**US-A- 4 210 993**

(73) Proprietor: **THORN EMI North America Inc.**
**P.O. Box 16000**
**Colorado Springs Colorado 80935(US)**

(72) Inventor: **Ryden, William D.**
**3348 Springridge Circle**
**Colorado Springs Colorado 80906(US)**
Inventor: **Hanson, Matthew V.**
**11 West Cheyenne Boulevard**
**Colorado Springs Colorado 80906(US)**
Inventor: **Derbenwick, Gary F.**
**1626 Vickers Drive**
**Colorado Springs Colorado 80907(US)**
Inventor: **Gnadinger, Alfred P.**
**19 Leaming Road**
**Colorado Springs Colorado 80906(US)**
Inventor: **Adams, James R.**
**1038 Oak Hills Drive**
**Colorado Springs Colorado 80919(US)**

(74) Representative: **Palmer, Roger et al**
**PAGE, WHITE & FARRER 54 Doughty Street**
**London WC1N 2LS(GB)**

## Description

This invention relates to a method of fabricating a MOS transistor on a substrate. It is particularly directed to improved processing techniques for fabricating MOS (metal oxide semiconductor) transistors in a large scale integrated circuit.

A MOS transistor generally includes source/drain regions in a substrate, and a gate electrode formed above the substrate between the source/drain regions and separated from the substrate by a relatively thin dielectric. The relative alignment of the gate with its source/drain regions is an important factor which influences the performance of the transistor.

Conventional fabrication techniques usually cause edges of the source/drain regions to be initially substantially vertically aligned with the edges of their gate. In subsequent heat treatment steps, however, the source/drain regions diffuse laterally. This results in the edges of the gate overlapping the source/drain regions. Consequently, undesired gate-drain overlap and Miller capacitances are created and the operating speed of the transistor is reduced.

IBM Technical Disclosure Bulletin, Volume 24, No. 7A December 1981, pages 3417-3419 shows a technique for fabricating a MOS transistor in which an implant mask on the sides of the gate electrode shields an underlying portion of the substrate from implantation so that initially there is a gap between the side edge of the gate electrode and a side edge of the implanted region.

GB-A-2074374A discloses a technique for fabricating an MOS transistor in which a layer of insulating oxide is put down over the substrate, a layer of polysilicon is then deposited followed by a further layer of oxide. The polysilicon and further oxide layer are then etched to define a gate electrode with an oxide cap. A separate oxide layer is then grown which forms an implant mask on the side wall of the gate and augments the thickness of the oxide cap.

US-A-4210993 discloses a technique for fabricating an MOS transistor in which a gate is defined by etching from a layer of polysilicon placed on a semiconductor substrate with an intervening layer of gate oxide. A silicon dioxide film is grown by thermal oxidation so that the oxide layer produced on the surface of the gate is thicker than the oxide film produced on the substrate. The oxide layer on the sides of the gate then acts as an implant mask.

Reference is also made to EP-A-0072967 forming part of the state of the art under Article 54(3) of the European Patent Convention, and in which an oxide layer formed over the gate acts as an implant mask for forming the source and drain regions. This oxide layer is grown by thermal oxidation so that the oxide layer produced on the surface of the gate is thicker than the oxide film over the source and drain regions.

According to the present invention there is provided a method of fabricating on a substrate a MOS transistor having a gate electrode and a self-aligned source/drain region, the method comprising the steps of:

a) forming a doped polysilicon gate electrode upon but insulated from the substrate;

b) then differentially thermally growing an oxide to a controlled thickness on the top and sides of the gate electrode and over the substrate adjacent the gate electrode, the oxide on the top and sides of the gate electrode being relatively thick compared to the oxide over an intended source/drain region of the substrate;

c) then anisotropically etching said oxide such that said oxide defines an implant mask on the sides of the gate electrode; and

d) implanting at least one source/drain region in the substrate such that the implant mask shields an underlying portion of the substrate from implantation to provide a gap between a side edge of the gate electrode and a side edge of the implanted region, characterised by before step b) implanting nitrogen while protecting the gate electrode from the implant; and by the step of heat driving the implanted source/drain region until its side edge is substantially aligned with the previously separated side edge of the gate electrode, wherein the width of the oxide on the sides of the gate electrode is controlled in step b) such that the step of heat driving causes the source/drain edge to be substantially aligned with the gate electrode edge with substantially zero overlap.

According to a further aspect of the invention there is provided a method of fabricating on a substrate a MOS transistor having a gate electrode and a pair of source/drain regions, comprising forming a relatively thin gate insulator over the substrate and over the intended source/drain regions defining a polysilicon gate electrode over the gate insulator between the intended source/drain regions, establishing a dielectric layer over the gate electrode and the gate insulator such that the dielectric is relatively thick at least over the sides of the gate electrode and relatively thinner over the intended source/drain regions and implanting the source/drain regions such that they are laterally offset from the substrate area below the gate electrode by the thickness of the dielectric layer on the sides of the gate electrode characterised by before the step of establishing a dielectric layer over the gate electrode, nitrogen is implanted while protecting the gate electrode from the implant and by heat driving the source/drain regions laterally until their edges are substantially vertically aligned with the sides of the gate electrode, etching contact areas so as to lay bare the substrate holding the source/drain regions and yet maintaining the dielectric on the sides of the gate electrode, and forming conductive contacts in the etched areas, whereby the source/drain regions are properly aligned with the gate electrode and the metal contacts are aligned with the source/drain regions without shorting the gate electrode.

Some ways of carrying out the invention are described below, by way of example, with reference to the accompanying drawings, in which:-

FIGURES 1 to 4 show in sequence the construction of an exemplary MOS transistor fabricated in accordance with the invention,

FIGURE 5 is a simplified top view of a transistor fabricated as shown in Figures 1 to 4,

FIGURES 6 and 7 illustrate an alternative embodiment of a method of fabricating an MOS transistor,

FIGURE 8 illustrates a variation on the method shown in Figures 6 and 7,

FIGURES 9 and 10 illustrate how an MOS transistor is made using an implant mask of photoresist, and

FIGURE 11 shows a variation on the method illustrated in Figures 9 and 10.

In the following description, a method is described for controlling the alignment of the source/drain regions of a typical MOS transistor with its polysilicon gate electrode, and for forming self-aligned source/drain contacts. Thereafter, alternate techniques are described for achieving the same result in applications where polysilicon or other gate materials are used, and which provide control over various other aspects of fabrication. As described more specifically below, the self-aligned source/drain regions are formed even into bare silicon, if desired, while simultaneously providing an isolating layer of dielectric, for example, on the gate of the transistor.

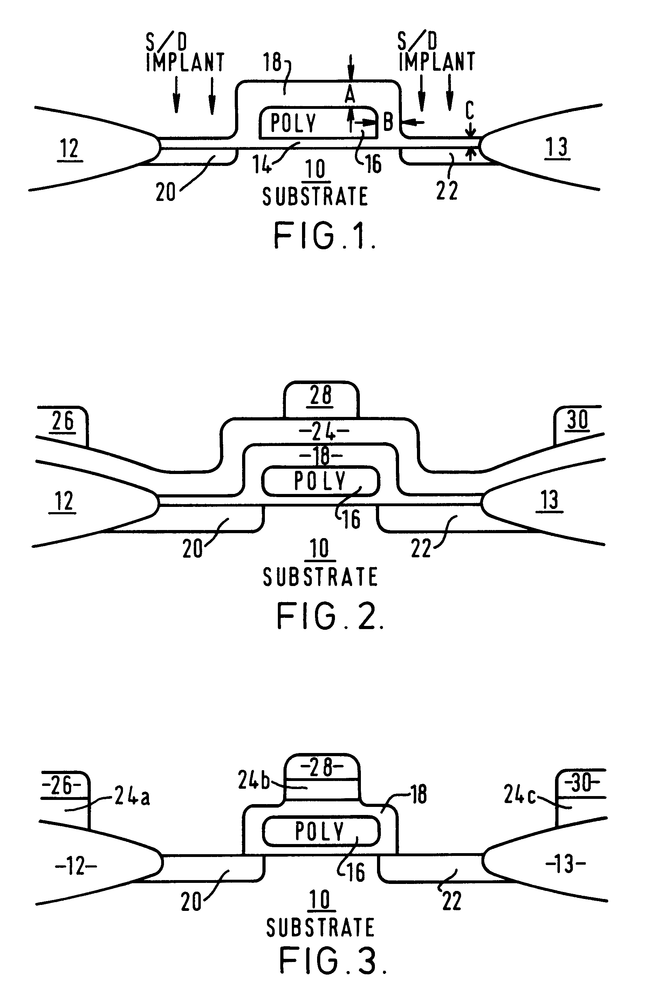

The way in which an exemplary MOS transistor is constructed with self-aligned source/drains to provide a reduced Miller capacitance and self-aligned contacts will now be described with reference to Figures 1 to 4. These figures illustrate the various stages of transistor construction whch are effected by various steps in the method of fabrication.

Referring first to Figure 1, there is shown a substrate 10 and field oxide regions 12 and 13 which are formed in a conventional manner, such as by local oxidation. Between these field oxide regions, an MOS transistor is fabricated by first forming a gate oxide 14 in the usual manner. Next, a polysilicon layer, designated Poly and doped to a sheet resistance of about 20 ohms per square, is defined and etched using photoresist patterning techniques. This leaves a Poly gate electrode 16 disposed above the transistor's intended channel.

A dielectric layer 18 of oxide is then established on the top and sides of the gate electrode 16 and over the substrate adjacent the gate electrode such that the oxide layer on the top and sides of the gate electrode is relatively thick compared to the oxide layer adjacent the gate electrode over the intended source/drain regions. This is preferably acomplished by steam oxidation at 850°C until about 500 nanometres of the oxide 18 are provided over the top (dimension A) of the gate electrode. This step of differentially growing the oxide provides a substantially similar oxide thickness on the side (dimension B) of the gate electrode and a relatively thin oxide layer (dimension C) over the intended source/drain regions. This thickness of the oxide layer at C will typically be about 170 nanometres because the oxide grows faster over the top and sides of the doped gate electrode. Irrespective of the specific dimensions of the oxide layer 18, the thickness of the oxide on the sides of the gate electrode (dimension B) is chosen so that later implanted sources and drains will be closely aligned with the vertical edges of the gate electrode 16 at the conclusion of transistor fabrication without any substantial gap or overlap between the source/drain regions and the gate electrode. That is, the oxide on the sides of the gate electrode acts as an implant mask to shield underlying portions of the substrate from implantation.

Having established the oxide layer 18, source/drain regions are implanted with arsenic or phosphorus, for example, to a depth which may be about 0.3 micron at a dose of about $6 \times 10^{15}$ ions per square centimetre. Because of the masking effect provided by the oxide on the sides of the gate electrode 16, the source/drain regions 20 and 22 are not implanted adjacent the vertical edges of the gate electrode. Rather, a gap is provided between the gate electrode 16 and the source/drain regions to allow for subsequent diffusion of the source/drain regions.

It is required to increase the thickness (dimension A) of the layer 18 in order to provide improved isolation and it may be desirable to independently control or reduce the thickness C such as to implant the source/drain regions through a thinner oxide or no oxide at all. Accordingly, an anisotropic etch is used to remove or thin the oxide layers which overlie the source/drain regions. The anisotropic etch may be a plasma etch as described below. By using an anisotropic etch, the sidewall oxides (dimension B) are not substantially thinned and the gap between the gate electrode and the implanted source/drain regions is about 500 nanometres. However, it may be desirable to modify the anisotropy of the etch to controllably thin the oxide on the sidewall of the gate electrode to provide a smaller gap, 300 nanometres for example, where subsequent heat treatments are known to provide less lateral diffusion of the source/drain regions.

After the source/drain regions have been implanted, standard processing occurs, including heat treating the structure. During such heat treatment, the implanted source/drain regions are driven deeper (to about 0.7 micrometre, for example) and driven laterally into substantial alignment with the vertical edges of the gate electrode (Figure 2). Good alignment is achieved by establishing the thickness of the oxide layer 18 on the sides of the gate electrode so that the known heat treatments which follow cause the edges of the source/drain regions to be driven laterally by a distance which is substantially equal to dimension B.

A nitrogen implant is used prior to forming the oxide layer 18 (Figure 1) to reduce the rate of oxidation over the source/drain regions while not affecting the rate of oxidation on Poly. During this nitrogen implantation, the gate electrode is protected from the implant by a photoresist layer. Source/drain implants may then be done after the oxide layer 18 is formed, and source/drain drive-in can be tailored to prevent overlap between the Poly gate electrode and the source/drain regions.

After the heat treatment, an intermediate oxide layer 24 is deposited to a depth of about 500 nanometres, for example. As shown in Figure 2, this intermediate oxide layer preferably covers the entire structure, including the field oxide regions 12 and 13.

Contact regions for the gate electrode and the source/drain regions are established by pattern-defining a photoresist layer at 26, 28 and 30. As shown, a contact region is thus formed between photoresists 26 and 28. This contact region overlaps the field oxide region 12 and the gate electrode. A similar overlap is created in the are between photoresists 28 and 30.

Next, the oxide layers 18 and 24 are removed from the contact areas so that the substrate is exposed above the source/drain regions, preferably by using a plasma etch. The field oxide not masked by photoresist is also laid bare, and the unmasked oxide layer 18 which overlies the gate electrode may be thinned. Such a plasma etch may, for example, be carried out in a reactive plasma etcher capable of anisotropic etching. A parallel plate reactor with close spacing (about 2 centimetres) between the plates is effective using 50% $CHF_3$ and 50% $C_2F_6$ at a total pressure of about 93.1 Pa (700 millitorrs) and a power of about 2000 watts.

At this point, it should be understood that the dielectric layers 18 and 24 may be made of either similar materials or different materials. It may be desired to use different material to provide an etch stop which avoids thinning dielectric 18 over the gate electrode.

Where the dielectrics 18 and 24 are of a similar material such as silicon dioxide, a thin layer of another dielectric such as a nitride may be deposited on the dielectric 18 prior to forming the dielectric 24. This also prevents the etching from removing the oxide 18 whilst the dielectric 24 is being removed. In any case, and oxide layer 18 will remain on the gate electrode 16 to facilitate the formation of self-aligned contacts or interconnnects for the source/drain regions.

The directional etching described above provides the structure shown in Figure 3 in which an intermediate oxide layer 24a and a photoresist 26 are left over the illustrated portion of the field oxide 12. The illustrated portion of the field oxide 13 is covered by an intermediate oxide layer 24c and photoresist 30, and the central portion of the remaining oxide layer is covered by an intermediate oxide layer 24b and photoresist 28.

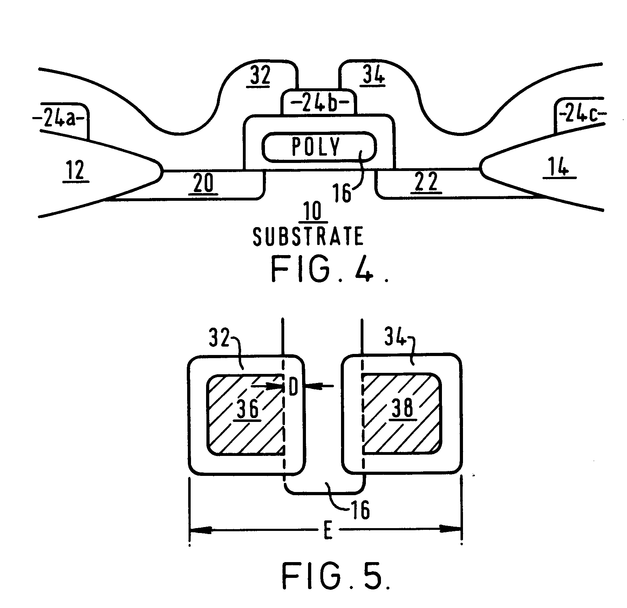

Referring now to Figure 4, the photoresists are removed in a conventional manner and an interconnect contacting layer 32, 34 such as aluminium or polysilicon, is provided so that the interconnect 32 overlies the source/drain region 20 and overlaps both the Poly gate and the field oxide 12. Likewise, the interconnnect 34 overlies the source/drain region 22 and overlaps both the Poly gate and the field oxide region 13. These interconnect patterns may be used to electrically contact the source/drain and gate regions in the usual manner.

The fabrication tehnique described above has several advantages. Chief among thse is the lack of undesired overlap between the finally processed source/drain regions and the Poly gate. Consequently, the transistor has reduced Miller capacitance and, therefore, operates faster. In addition, the width of the Poly gate is substantially equal to the transistor's electrical channel length. This allows transistors with longer channel characteristics to be fabricated with smaller physical dimensions.

Another significant advantage of this fabrication technique is that the source/drain contacts can be self-aligning. This result is obtained because the technique allows etching to the substrate over the source/drain regions while the oxide layer 18 protects the Poly gate. Even if the photoresist 28 is misaligned with respect to the gate 16, the oxide 18 prevents shorts to the gate when the interconnects 32, 34 are provided for the source/drain regions.

The manner in which the interconnects are provided also contributes substantially to a reduction in transistor size. As shown in the simplified top view depicted in Figure 5, the interconnect patterns 32 and 34 overlap the Poly 16 while covering the active areas designated by the shaded regions 36 and 38. Typically, the Poly and the active areas are about 2 microns wide, and an overlap of about .5 micrometre (dimension D) exists between the interconnect patterns and the Poly. Consequently, the size (dimension E) of the transistor is reduced to about 7 microns or less.

Several alternatives are available for practicing the present fabrication technique. For example, the use of the intermediate oxide layer 24 may be eliminated and contact areas may be defined by a non-selective etch. The resulting structure would be substantially as shown in Figure 4, except that the intermediate oxide would not be present. This technique is useful in forming self-aligned buried contacts.

The method described with reference to Figures 1-4 utilizes the differential growth rate of dielectric over the gate electrode and over the source/drain regions to provide self-aligned, non-overlapping source/drain regions.

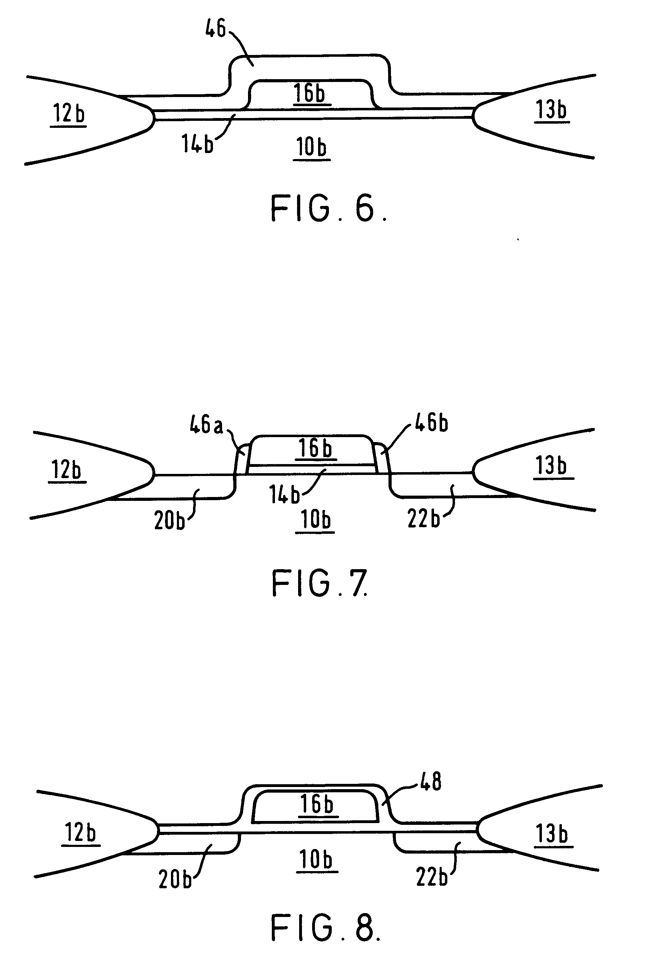

Alternative fabrication methods are shown in figures 6 to 11, and in these Figures, material and structure which correspond to the materials and structure of Figures 1 to 4 have corresponding reference numerals followed by a character.

Figures 6 and 7 show a method which may be used when it is desired to dope the polysilicon gate at the same time as the source/drain regions are doped. As shown in Figure 6, in this alternative method a dielectric 14b is established over the substrate 10b and then a polysilicon gate 16b is defined over the dielectric 14b. Another dielectric 46, such as silicon dioxide, is then deposited or grown over the entire structure. The dielectric 46 is anisotropically etched, as by the previously described plasma etch, to expose the bare silicon substrate and the top of the gate electrode 16b as shown in Figure 7. Because of the unidirectional etch, remnants 46a and 46b of the dielectric are left on the sides of the gate electrode to mask the implantation of the sosurce/drain regions 20b and 22b. The gate electrode 16b may now be doped at the same time that the source/drain regions are implanted.

Comparing Figures 1 and 7, it can be seen that similar structures are provided except that the gate 16b of Figure 7 is not covered by dielectric. Subsequent fabrication steps are similar to those described previously for heat driving the source/drain regions into alignment with the vertical edges of the gate electrode 16b, and for establishing the self-aligned contacts.

It is somtimes preferred to leave a thin layer of oxide over the source/drain regions 20b and 22b during implantation. This variant is shown in Figure 8 in which an oxide layer 48, having a thickness typically less than 100 nanometres, is grown or deposited over the gate 16b, over the remanants 46a and 46b (not shown separately in Figure 8), and over the substrate.

Source/drain regions 20b and 22b may then be implanted through the oxide layer 48 while the gate electrode 16b is simultaneously doped.

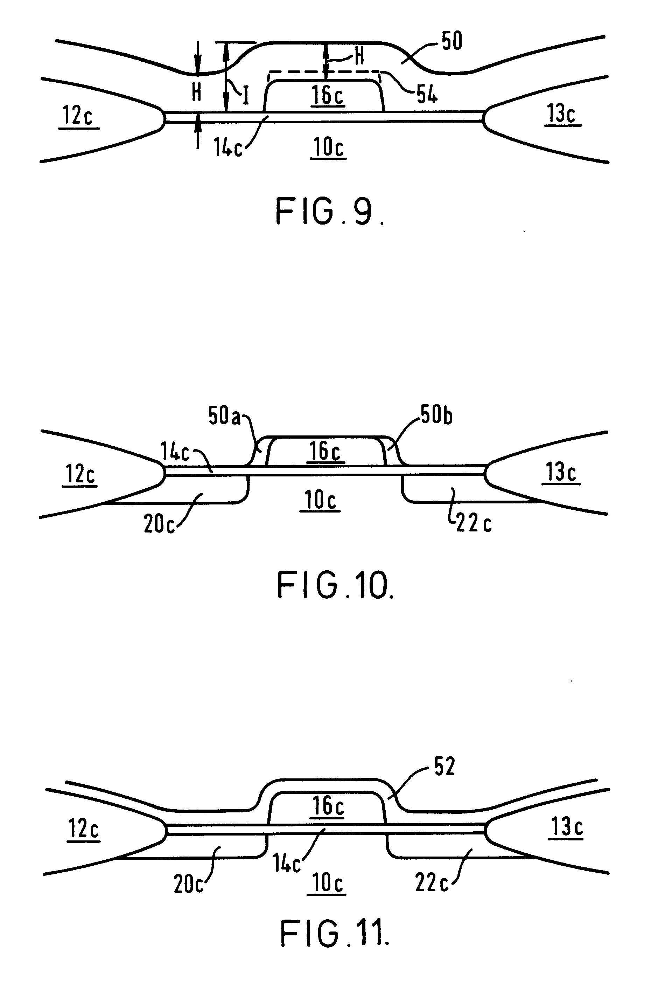

The remnants on the sides of the gate electrode, as shown in Figure 7 may be formed of material other than dielectric. One such material is photoresist, and it may be utilized as described in connection with Figures 9 and 10. Referring first to Figure 9, a dielectric 14c is established over the substrate 10c in the usual manner, and a gate electrode 16c of polysilicon, for example, is defined over the intended channel of the transistor. A layer of photoresist material 50 is then conformally established in a conventional manner over the entire structure. This results in a layer of photoresist having a depth H over the intended source/drain regions and over the gate electrode 16c. A greater depth I of photoresist occurs in the areas adjacent the sides of the gate electrode.

The photoresist is then exposed and developed conventionally or anisotropically etched so as to remove a thickness H of it. Because of the greater depth of the photoresist at the areas adjacent the gate electrode, photoresist remnants or fillets 50a and 50b (Figure 13) remain on the sides of the gate electrode. These fillets serve, of course, to mask the source/drain implantation as described in the other examples.

The source/drain regions 20c and 22c may now be implanted. Because the gate electrode 16 is uncovered, this implantation also dopes the gate electrode.

After the structure shown in Figure 10 has been obtained, the photoresist fillets 50a and 50b are stripped conventionally. Then an oxide layer 52 (Figure 11) may be established over the entire structure. Preferably, about 50 nanometres of the oxide 52 are grown thermally and the remainder is deposited. Next, the previously described processing occcurs, including the heat treatment which drives the source/drain regions 20c and 22c into the depicted non-overlapping alignment with the vertical edges of the gate electrode 16c.

When it is not desired to dope the gate electrode during source/drain implant, a layer of oxide may be deposited over the gate material prior to the application of the photoresist. The gate material and oxide may then be defined to form a gate electrode in which an oxide is on top of the gate electrode material. The photoresist may then be applied and selectively removed as previously described, with the result that an oxide layer 54 (Figure 9) separates the photoresist from the top of the gate electrode. This oxide layer prevents the gate material from being doped during source/drain implantation.

Although various methods have been described for fabricating an MOS device, all such methods provide an implant mask which ensures that the source/drain regions are properly aligned with the gate electrode at the conclusion of fabrication. In addition, the implant mask serves to isolate the gate electrode, particularly its edges, from interconnects so that the patterns which define the interconnects need not be held to tight tolerances.

**Claims**

1. A method of fabricating on a substrate a MOS transistor having a gate electrode and a self-aligned source/drain region, the method comprising the steps of:
   a) forming a doped polysilicon gate electrode (16) upon but insulated from the substrate (10);
   b) then differentially thermally growing an oxide (18) to a controlled thickness on the top and sides of the gate electrode (16) and over the substrate (10) adjacent the gate electrode, the oxide on the top and sides of the gate electrode being relatively thick compared to the oxide over an intended source/drain region of the substrate;
   c) then anisotropically etching said oxide (18) such that said oxide defines an implant mask on the sides of the gate electrode (16); and
   d) implanting at least one source/drain region (20,22) in the substrate (10) such that the implant mask (18) shields an underlying portion of the substrate (10) from implantation to provide a gap between a side edge of the date electrode and a side edge of the implanted region, further comprising the step of implanting nitrogen before step b) while protecting the gate electrode from the implant; and the step of heat driving the implanted source/drain region (20,22) until its side edge is substantially aligned with the previously separated side edge of the gate electrode (16), wherein the width of the oxide on the sides of the gate electrode is controlled in step b) such that the step of heat driving causes the source/drain edge to be substantially aligned with the gate electrode edge with substantially zero overlap.

2. A method as claimed in claim 1, wherein the oxide is grown in steam at a temperature of about 850°C.

3. A method as claimed in claim 1 or 2, wherein the source/drain region (20,22) is implanted through the relatively thin oxide layer over the substrate.

4. A method as claimed in claim 1 or 2, wherein said step of anisotropically etching removes the oxide (18) over the intended source/drain region (20,22) and yet leaves masking oxide (B) on the sides of the gate electrode (16).

5. A method as claimed in any preceding claim, further comprising, after said implanting step d), forming an intermediate dielectric (24) over both the gate electrode (16) and the source/drain region (20,22), patterning a contact area over the source/drain region (20,22) to overlie the source/drain region and overlap the oxide on the gate electrode (16), etching dielectric (24) in the contact area down to the substrate (10) while leaving the oxide (18) on the sides and top of the gate electrode (16), and providing a conductive material (32,34) in the etched contact area to provide a contact for the source/drain region (20,22), whereby a self-aligned contact is formed such that the gate electrode (16) is prohibited by the oxide (18) over the gate electrode from being shorted in the event that the patterned contact area is misaligned.

6. A method as claimed in any preceding cliam, wherein said gate electrode (16) is polysilicon doped to a sheet resistance of about 20 ohms per square.

7. A method as claimed in any preceding claim, wherein the oxide is anisotropically etched to leave oxide on at least the sides of said gate electrode (16b), and the source/drain region (20b,22b) is implanted while the top of the gate electrode (16b) is substantially free of oxide for doping the gate electrode (16b) during source/drain implantation.

8. A method as claimed in claim 7, wherein a relatively thin oxide (48) is formed over the gate electrode (16b), the oxide remnants (46a,46b) on the sides of the gate electrode, and the intended source/drain region (22a,22b) prior to implantation.

9. A method of fabricating on a substrate a MOS transistor having a gate electrode and a pair of source/drain regions, comprising forming a relatively thin gate insulator (14) over the substrate (10) and over the intended source/drain regions (20,22) defining a polysilicon gate electrode (16) over the gate insulator (14) between the intended source/drain regions (20,22), establishing a dielectric layer (18) over the gate electrode (16) and the gate insulator (14) such that the dielectric (18) is relatively thick at least over the sides of the gate electrode (16) and relatively thinner over the intended source/drain regions (20,22) and implanting the source/drain regions such that they are laterally offset from the substrate area below the gate electrode (16) by the thickness of the dielectric layer (18) on the sides of the gate electrode (16) further comprising the step of implanting nitrogen before the step of establishing a dielectric layer over the gate electrode while protecting the gate electrode from the implant and the step of heat driving the source/drain regions (20,22) laterally until their edges are substantially vertically aligned with the sides of the gate electrode (16), etching contact areas so as to lay bare the substrate (10) holding the source/drain regions (20,22) and yet maintaining the dielectric (18) on the sides of the gate electrode (16), and forming conductive contacts (32,34) in the etched areas, whereby the source/drain regions (20,22) are properly aligned with the gate electrode (16) and the metal contacts (32,34) are aligned with the source/drain regions (20,22) without shorting the gate electrode (16).

**Patentansprüche**

1. Verfahren zum Herstellen eines MOS-Transistors auf einem Substrat, der eine Gate-Elektrode und einen selbstausrichtenden Source-/Drain-Bereich aufweist, wobei das Verfahren die Schritte umfaßt:

   a) Ausbilden einer dotierten Polysilizium-Gate-Elektrode (16) auf und isoliert von dem Substrat (10);

   b) dann differentiales thermisches Aufwachsen eines Oxides (18) bis zu einer bestimmten Dicke an der Oberseite und den Seiten der Gate-Elektrode (16) und über dem Substrat (10), das an die Gate-Elektrode grenzt, wobei das Oxid an der Oberseite und den Seiten der Gate-Elektrode verglichen zu dem Oxid über einem beabsichtigten Source-/Drain-Bereich des Substrates relativ dick ist;

   c) dann anisotropisches Ätzen des Oxides (18), wodurch das Oxid eine implantierte Maske auf den Seiten der Gate-Elektrode (16) abgrenzt; und

   d) Implantieren wenigstens eines Source-/Drain-Bereiches (20,22) in dem Substrat (10) derart, daß die implantierte Maske (18) einen darunterliegenden Abschnitt des Substrates (10) vor Implantation schützt, um einen Spalt zwischen einer Seitenkante der Gate-Elektrode und einer Seitenkante des implantierten Bereichs auszubilden, wobei weiter der Verfahrensschritt vorgesehen ist: Implantieren von Stickstoff vor dem Verfahrensschritt b), während die Gate-Elektrode vor dem Implantat geschützt ist; und der Verfahrensschritt des Hitzeeinwirkens auf den implantierten Source-/Drain-Bereich (20,22) bis dessen Seitenkante im wesentlichen mit den zuvor getrennten Seitenkanten der Gate-Elektrode (16) ausgerichtet ist, wobei die Breite des Oxides auf den Seiten der Gate-Elektrode im Verfahrensschritt b) derart gesteuert wird, daß der Verfahrensschritt des Hitzeeinwirkens die Source-/Drain-Kanten veranlaßt, sich im wesentlichen mit der Gate-Elektroden-Kante mit im wesentlichen keiner Überlappung auszurichten.

2. Verfahren nach Anspruch 1, dadurch gekennzeichnet, daß das Oxid in Dampf mit einer Temperatur von ungefähr 850°C aufgewachsen wird.

3. Verfahren nach Anspruch 1 oder 2, dadurch gekennzeichnet, daß der Source-/Drain-Bereich (20,22) durch die relativ dünne Oxidschicht über dem Substrat implantiert wird.

4. Verfahren nach Anspruch 1 oder 2, dadurch gekennzeichnet, daß der Verfahrensschritt des anisotropischen Ätzens die Oxide (18) über den vorgesehen Source-/Drain-Bereichen (20,22) entfernt und noch Abdeckoxid (B) an den Seiten der Gate-Elektrode (16) beläßt.

5. Verfahren nach einem der vorgenannten Ansprüche, dadurch gekennzeichnet, daß weiter nach dem Implantierschritt d) vorgesehen ist, ein Zwischendielektrikum (24) über den beiden Gate-Elektroden (16) und Source-/Drain-Bereichen (20,22) auszubilden, einen Kontaktbereich über dem Source-/Drain-Bereich (20,22) aufzumustern, um den Source-/Drain-Bereich abzudecken und das Oxid auf der Gate-Elektrode (16) zu überlappen, das Dielektrikum (24) in dem Kontaktbereich bis hinunter zu dem Substrat (10) zu ätzen, während das Oxid (18) an den Seiten und der Oberseite der Gate-Elektrode (16) verbleibt, und

ein leitfähiges Material (32,34) in dem geätzten Kontaktbereich auszubilden, um einen Kontakt für den Source-/Drain-Bereich (20,22) zu schaffen, wodurch ein sich selbstausrichtender Kontakt derart geformt wird, daß die Gate-Elektrode (16) durch das Oxid (18) über der Gate-Elektrode bewirkt, für den Fall keinen Kontakt herzustellen, wenn der gemusterte Kontaktbereich fehlerhaft fluchtet.

6. Verfahren nach einem der vorgenannten Ansprüche, dadurch gekennzeichnet, daß die Gate-Elektrode (16) Polysilizium auf einen Flächenwiderstand von ungefähr 20 Ohm pro Flächenprobe dotiert ist.

7. Verfahren nach einem der vorgenannten Ansprüche, dadurch gekennzeichnet, daß das Oxid anisotropisch geätzt wird, um wenigstens an den Seiten der Gate-Elektrode (16b) Oxid zu belassen, und daß der Source-/Drain-Bereich (20b,22b) implantiert wird, während die Oberseite der Gate-Elektrode (16b) im wesentlichen frei von Oxid zur Dotierung der Gate-Elektrode (16b) während der Source-/Drain-Implantation ist.

8. Verfahren nach Anspruch 7, dadurch gekennzeichnet, daß ein relativ dünnes Oxid (48) über der Gate-Elektrode (16b), den Oxidrestbestandteilen (46a, 46b) auf den Seiten der Gate-Elektrode und dem vorgesehenen Source-/Drain-Bereich (22a, 22b) vor der Implantation ausgebildet wird.

9. Verfahren zum Herstellen eines MOS-Transistors auf einem Substrat, der eine Gate-Elektrode und ein Paar von Source-/Drain-Bereichen aufweist, bei dem ein relativ dünner Gate-Isolator (14) über dem Substrat (10) und über den vorgesehenen Source-Drain-Bereichen (20, 22) ausgebildet wird, eine Polysilizium-Gate-Elektrode (16) über dem Gate-Isolator (14) zwischen den vorgesehenen Source-/Drain-Bereichen (20, 22) festgelegt wird, eine dielektrische Schicht (18) über der Gate-Elektrode (16) und dem Gate-Isolator (14) errichtet wird, so daß das Dielektrikum (18) wenigstens über den Seiten der Gate-Elektrode (16) relativ dicker und über den vorgesehenen Source-/Drain-Bereichen (20, 22) relativ dünner ist, und die Source-/Drain-Bereiche derart implantiert werden, daß diese von dem Substratbereich unter der Gate-Elektrode (16) durch die Dicke der dielektrischen Schicht (18) an den Seite der Gate-Elektrode (16) zeitlich verschoben werden, und weiter die Verfahrensschritte vorgesehen sind, Stickstoff vor dem Verfahrensschritt des Errichtens einer dielektrischen Schicht über der Gate-Elektrode zu implantieren, während die Gate-Elektrode vor dem Implantat geschützt ist, den Schritt des Erhitzens, der die Source-/Drain-Bereiche (20, 22) seitlich bewegt, bis deren Kanten im wesentlichen vertikal mit den Seiten der Gate-Elektroden ausgerichtet sind, Ätzen der Kontaktbereiche, um so das Substrat (10) freizulegen, das die Source-/Drain-Bereiche (20, 22) hält und weiter das Dielektrium (18) auf den Seiten der Gate-Elektrode (16) trägt, und Ausbilden leitfähiger Kontakte (32, 34) in den geätzten Bereichen, wodurch die Source-/Drain-Bereiche (20, 22) genau mit der Gate-Elektrode (16) ausgerichtet sind, und die Metallkontakte (32, 34) mit den Source-/Drain-Bereichen (20, 22) ohne Kurzschluß der Gate-Elektrode (16) ausgerichtet sind.

**Revendications**

1. Procédé de fabrication sur un substrat, d'un transistor MOS ayant une électrode de grille et une région de source/drain auto-alignée, le procédé comprenant les étape de :
   a) formation d'une électrode de grille (16) de silicium polycristallin dopé sur le substrat (10) mais isolé de celui-ci ;
   b) ensuite croissance thermique différentielle d'un oxyde (18) jusqu'à une épaisseur commandée sur le dessus et les côtés de l'électrode de grille (16) et sur le substrat (10) adjacent à l'électrode de grille, l'oxyde sur le dessus et les côtés de l'électrode de grille étant relativement épais par comparaison à l'oxyde sur une région du substrat destinée à être la région de source/drain ;
   c) ensuite gravure anisotrope dudit oxyde (18) de manière à ce que ledit oxyde définisse un masque d'implantation sur les côtés de l'électrode de grille (16) ; et
   d) implantation d'au moins une région de source/drain (20, 22) dans le substrat (10) de manière à ce que le masque d'implantation (18) protège de l'implantation une partie sous-jacente du substrat (10) pour fournir un écart entre un bord latéral de l'électrode de grille et un bord latéral de la région implantée, comprenant en outre l'étape d'implantation d'azote, avant l'étape b), tout en protégeant l'électrode de grille de l'implantation ; et l'étape de pilotage par la chaleur de la région de source/drain (20, 22) implantée jusqu'à ce que son bord latéral soit sensiblement aligné avec le bord latéral antérieurement séparé de l'électrode de grille (16), dans lequel la largeur de l'oxyde sur les côtés de l'électrode de grille est commandée dans l'étape b) de manière à ce que l'étape de pilotage par la chaleur fasse que le bord de la source/drain soit sensiblement aligné avec le bord de l'électrode de grille avec un chevauchement sensiblement nul.

2. Procédé tel que revendiqué dans la revendication 1, dans lequel l'oxyde est développé par croissance en phase vapeur à une température d'environ 850° C.

3. Procédé tel que revendiqué dans la revendication 1 ou la revendication 2, dans lequel la région de source/drain (20, 22) est implantée à travers la couche d'oxyde relativement mince sur le substrat.

4. Procédé tel que revendiqué dans la revendication 1 ou la revendication 2, dans lequel ladite étape de gravure anisotrope retire l'oxyde (18) sur la région destinée à être la région de source/drain (20, 22) et laisse masqué l'oxyde (B) sur les côtés de l'électrode de grille (16).

5. Procédé tel que revendiqué dans l'une quelconque des revendications précédentes, comprenant de plus, après ladite étape d'implantation d), la formation d'un diélectrique intermédiaire (24) sur à la fois l'électrode de grille (16) et la région de source/drain (20, 22), le dessin d'une zone de contact sur la région de source/drain (20, 22) pour recouvrir la région de source/drain et chevaucher l'oxyde sur l'électrode de grille (16), la gravure du diélectrique (24) dans la zone de contact jusqu'à la surface (10) tout en laissant l'oxyde (18) sur les côtés et le dessus de l'électrode de grille (16), et la mise en place d'un matériau conducteur (32, 34) dans la zone de contact gravée pour réaliser un contact pour la région de source/drain (20, 22), ce par quoi un contact auto-aligné est formé de manière à ce que l'électrode de grille (16) soit empêchée par l'oxyde (18) sur l'électrode de grille d'être raccourcie dans le cas où la zone de contact dessinée serait mal alignée.

6. Procédé tel que revendiqué dans l'une quelconque des revendications précédentes, dans lequel ladite électrode de grille (16) est du silicium polycristallin dopé jusqu'à une résistance de couche d'environ 20 ohms par carré.

7. Procédé tel que revendiqué dans l'une quelconque des revendications précédentes, dans lequel l'oxyde est gravé de manière anisotrope pour laisser de l'oxyde sur au moins les côtés de ladite électrode de grille (16b), et dans lequel la région de source/drain (20b, 22b) est implantée tandis que le dessus de l'électrode de grille (16b) est pratiquement exempt d'oxyde pour le dopage de l'électrode de grille (16b) pendant l'implantation de la source/drain.

8. Procédé tel que revendiqué dans la revendication 7, dans lequel un oxyde relativement mince (48) est formé sur l'électrode de grille (16b), les restes d'oxyde (46a, 46b) sur les côtés de l'électrode de grille, et la région destinée à être la région de source/drain (22a, 22b) avant l'implantation.

9. Procédé de fabrication sur un substrat d'un transistor MOS ayant une électrode de grille et une paire de régions de source/drain, comprenant la formation d'un isolant de grille (14) relativement mince sur le substrat (10) et sur les régions destinées à être les régions de source/drain (20, 22) en définissant une électrode de grille (16) de silicium polycristallin sur l'isolant de grille (14) entre les régions destinées à être les régions de source/drain (20, 22), l'établissement d'une couche diélectrique (18) sur l'électrode de grille (16) et l'isolant de grille (14) de manière à ce que le diélectrique (18) soit relativement épais au moins sur les côtés de l'électrode de grille (16) et relativement plus mince sur les régions destinées à être les régions de source/drain (20, 22), et implantation des régions de source/drain de manière à ce qu'elles soient décalées latéralement, par rapport à la surface du substrat située sous l'électrode de grille (16), de l'épaisseur de la couche diélectrique (18) située sur les côtés de l'électrode de grille (16), comprenant en outre l'étape d'implantation d'azote, avant l'étape d'établissement d'une couche diélectrique sur l'électrode de grille, tout en protégeant l'électrode de grille de l'implantation, et l'étape de pilotage par la chaleur des régions de source/drain (20, 22), latéralement, jusqu'à ce que leurs bords soient sensiblement alignés verticalement avec les côtés de l'électrode de grille (16), la gravure de zones de contact de manière à mettre à nu le substrat (10) contenant les régions source/drain (20, 22) et à conserver le diélectrique (18) sur les côtés de l'électrode de grille (16), et la formation de contacts conducteurs (32, 34) dans les zones gravées, ce par quoi les régions de source/drain (20, 22) sont correctement alignées avec l'électrode de grille (16) et les contacts métalliques (32, 34) sont alignés avec les régions de source/drain (20, 22) sans raccourcissement de l'électrode de grille (16).

S/D
IMPLANT

18

A

S/D
IMPLANT

C

POLY

B

12

20

14

10
SUBSTRATE

16

22

13

## FIG.1.

26

28

-24-

-18-

POLY

30

12

20

16

10
SUBSTRATE

22

13

## FIG.2.

-26-

24a

-28-

24b

18

-30-

24c

-12-

POLY

16

20

10
SUBSTRATE

22

-13-

## FIG.3.

FIG. 4.

FIG. 5.

FIG. 6.

FIG. 7.

FIG. 8.

FIG.9.

FIG.10.

FIG.11.